(19) Europäisches Patentamt
European Patent Office
Office européen des brevets

(11) Numéro de publication : **0 058 577**
**B1**

# (12) FASCICULE DE BREVET EUROPÉEN

(45) Date de publication du fascicule du brevet : **13.06.84**

(51) Int. Cl.³ : **H 01 L 29/80**

(21) Numéro de dépôt : **82400033.5**

(22) Date de dépôt : **08.01.82**

**(54) Dispositif semiconducteur de déviation d'électrons du type "à transport balistique", et procédé de fabrication d'un tel dispositif.**

(30) Priorité : **27.01.81 FR 8101466**

(43) Date de publication de la demande : **25.08.82 Bulletin 82/34**

(45) Mention de la délivrance du brevet : **13.06.84 Bulletin 84/24**

(84) Etats contractants désignés : **DE GB IT NL**

(56) Documents cités :
**US-A- 3 560 963**
**IEEE TRANSACTIONS ON ELECTRON DEVICES, vol. ED-27, no. 6, juin 1980 New York (US) C.O. BOZLER et al.: "Fabrication and Numerical Simulation of the Permeable Base Transistor", pages 1128-1141**

(73) Titulaire : **THOMSON-CSF**
**173, Boulevard Haussmann**
**F-75379 Paris Cedex 08 (FR)**

(72) Inventeur : **Jay, Paul Robert**
**THOMSON-CSF SCPI 173, bld Haussmann**
**F-75360 Paris Cedex 08 (FR)**

(74) Mandataire : **Wang, Pierre èt al**
**THOMSON-CSF SCPI 173, Bld Haussmann**
**F-75379 Paris Cedex 08 (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

EP 0 058 577 B1

## Description

L'invention concerne un dispositif semiconducteur comportant une structure analogue à celle des transistors à effet de champ du type « à électrons balistiques » avec laquelle on se propose de créer, par des moyens nouveaux, une déviation des « électrons balistiques » de façon à commuter de façon ultra-rapide un courant ou un signal ou encore pour déphaser un signal dans le temps. L'invention comprend également un procédé de fabrication d'un tel dispositif.

On sait que, dans certaines conditions, les électrons qui se déplacent sous l'effet d'un champ électrique dans un milieu semiconducteur, tel que l'arséniure de gallium, le phosphure d'indium ou l'alliage indium-antimoine, peuvent effectuer, sur une distance inférieure au micron, des parcours pratiquement non perturbés en vitesse et en direction par les collisions avec d'autres particules. Ces électrons sont dits balistiques. Le temps de parcours des électrons, au sein d'un dispositif à transport balistique, doit être du même ordre que le temps moyen de relaxation d'un électron entre incidents entraînant une perte d'énergie par quelque mécanisme que ce soit dans le matériau semiconducteur.

On a réalisé des structures de transistors dits « à électrons balistiques » ou « à transport balistique », dans lesquelles sont canalisés, entre les mailles d'une grille enterrée en milieu semiconducteur, et franchissent très rapidement la distance très courte entre cathode et anode, c'est-à-dire entre source et drain du transistor à effet de champ constitué par la structure. De tels transistors ont une transconductance et une fréquence maximale plus élevée que les transistors habituels.

Toutefois de telles structures ne sont pas utilisables pour assurer certaines fonctions de commutations à grande vitesse ni de déphasage de très grande précision.

L'invention vise à remédier à ces inconvénients en modifiant assez profondément la structure du transistor à effet de champ à grille enterrée pour permettre la réalisation de commutateurs et de déphaseurs.

Dans le dispositif de l'invention, on trouve une structure comportant au moins une cathode, au moins une anode, ces deux électrodes étant situées de part et d'autre d'une lame semiconductrice permettant d'observer le phénomène des électrons balistiques et comportant une première électrode de grille enterrée.

Elle est caractérisée en ce qu'elle comporte une deuxième électrode de grille enterrée, des moyens étant prévus pour appliquer des tensions différentes à la première et à la deuxième électrode de grille, et suivant qu'il s'agit d'un commutateur ou d'un déphaseur ;

— une électrode supplémentaire d'anode ;

— ou une électrode anodique de longueur suffisante pour faire apparaître une différence de temps de parcours entre cathode et anode pour les électrons balistiques, lorsque ceux-ci sont dirigés en raison des polarisations différentes de grille sur différents points de l'électrode anodique.

L'invention sera mieux comprise, et d'autres caractéristiques apparaîtront, au moyen de la description qui suit, et des dessins qui l'accompagnent, parmi lesquels :

la figure 1 représente une première réalisation de l'invention, qui est un dispositif de commutation ;

la figure 2 représente une deuxième réalisation de l'invention, qui est un dispositif déphaseur ;

les figures 3 à 16 représentent différents stades de fabrication d'un dispositif selon l'invention.

Le dispositif de commutation représenté à la figure 1 comporte une lame 1 de matériau semiconducteur (en coupe partielle) qui peut être par exemple de l'arséniure de gallium monocristallin dont le degré de dopage, de type n, n'est pas critique, et peut se situer entre $5.10^{15}\,cm^{-3}$ et $10^{16}\,cm^{-3}$ atomes de dopant. L'épaisseur de cette lame 1 est inférieure au micron, ce qui pose des problèmes de tenue mécanique à la manutention. On verra par la suite que cette lame est le résultat d'une épitaxie sur un substrat que l'on attaque par un agent chimique sélectif après avoir collé préalablement la face épitaxiée sur un support en matériau isolant.

La lame 1 comporte :

a) une série de contacts ohmiques sur chacune de ses grandes faces :

— contacts 10 de source ;

— contacts 21 et 22 de cible.

Ces contacts sont représentés par un système de hachures empiétant sur le matériau de la lame 1.

b) une double rangée, parallèle aux contacts ohmiques, de contacts Schottky du type noyé dans l'épaisseur de la lame 1 (par un procédé qui est décrit par la suite).

Ces contacts sont reliés entre eux à l'extérieur de la lame par deux barres de grille $G_1$ et $G_2$.

On considère que ces ensembles de contacts forment, avec le matériau semiconducteur, une série de cellules XY délimitées par des plans de traces XX et YY sur la coupe de la figure 1.

Chaque cellule comporte :

— un contact de source 10 ;

— au moins deux contacts de drain ou cibles, 21 et 22 ;

— deux contacts noyés de grilles 31 et 32.

Il est prévu de mettre en parallèle les espaces source-drain des différentes cellules en vue d'obtenir un courant total d'autant plus grand qu'il existe davantage de cellules.

A cet effet, les contacts 10 sont multiplés sur une même borne 11, pôle négatif d'une source de tension V dont le pôle positif est, par exemple, à la masse du dispositif.

De façon analogue, les contacts 31 et 32 sont multiplés respectivement, par les barres de grille, sur les pôles négatifs de sources $V_1$ et $V_2$.

On dispose de moyens de commande des tensions $V_1$ et $V_2$ pour rendre alternativement $V_1$ ou $V_2$ supérieur à son homologue (en valeur absolue), les deux polarisations négatives $V_1$ et $V_2$ étant elles-mêmes plus fortes que la polarisation négative du contact de source 10.

Enfin les contacts 21 et 22 sont reliés à leurs homologues des cellules voisines et multiplés respectivement sur des appareils d'utilisation $R_1$ et $R_2$. On pourrait avoir trois ou quatre contacts de cible et trois ou quatre appareils d'utilisation.

Le fonctionnement du dispositif de commutation est le suivant. On considère la cellule située entre les plans de traces XX et YY sur le plan de la figure 1. Grâce à la polarité positive des contacts 21 et 22 un faisceau d'électrons se dirige de la source 10 vers les cibles 21 et 22. Mais le faisceau est orienté différemment selon les polarisations des grilles 31 et 32.

Premier cas : Si $V_2$ est, en valeur absolue, supérieur à $V_1$, les zones désertes 41 et 42 créées autour des contacts 31 et 32 sont des sphères de rayons inégaux, le rayon de la zone 41 étant le plus petit. Le faisceau d'électrons se divise en trois parts inégales :

— une partie $E_0$, la plus importante, se dirige obliquement vers la face qui porte les cibles, et, si les valeurs de $V_1$ et $V_2$ sont bien choisies, est captée par la cible 21. Il s'agit d'électrons balistiques, en raison des conditions initialement remplies par la lame semiconductrice. Pour cette raison, on observe que la majeure partie du faisceau d'électrons est effectivement captée par la cible ;

— les parties marginales $E_1$ et $E_2$ du faisceau ne sont pas captées par la cible 21, car elles sont perturbées par les zones désertes. En conclusion, presque aucun électron ne parvient à la cible 22.

Deuxième cas : Si $V_2$ est, en valeur absolue, inférieur à $V_1$, le fonctionnement est analogue mais c'est la cible 22 qui reçoit la majeure partie du faisceau d'électrons, tandis que la cible 21 n'en reçoit pratiquement pas.

On a donc bien réalisé une commutation de courant tantôt au profit d'un autre : $R_2$.

Le dispositif commutateur est constitué par la mise en parallèle des différentes cellules de la lame 1.

Parmi les avantages du commutateur selon l'invention on peut signaler ceux qui résultent de la réalisation à l'état solide et ceux qui sont imputables aux qualités de rapidité des électrons balistiques.

Le dispositif déphaseur représenté à la figure 2 comporte une lame 1 analogue à celle du dispositif de commutation représenté à la figure 1 sauf en ce qui concerne les contacts de cible. En effet, dans le cas présent on dépose, sur la grande face opposée aux contacts de source, un contact de cible 20, réalisé en contact ohmique et donc représenté comme tel. Ce contact unique occupe une surface assez grande pour être atteint dans tous les cas par le faisceau d'électrons. Ce contact est relié à la borne d'entrée d'un appareil d'utilisation R dont une autre borne est à la masse du dispositif.

Le fonctionnement est analogue à celui du dispositif précédent la majeure partie du faisceau d'électrons $E_0$ étant dirigée obliquement vers telle ou telle partie de la cible 20 suivant le rapport des valeurs absolues des tensions $V_1$ et $V_2$ ; il en résulte un déphasage plus ou moins important du signal traversant l'appareil d'utilisation R.

On décrit ci-après un exemple de procédé de fabrication d'un dispositif selon l'invention, dans le cas d'un commutateur à deux positions. Le procédé s'applique avec des modifications mineures au cas de commutateurs à plus de deux positions et au cas des déphaseurs.

On part d'un substrat 3 (figure 3) d'arséniure de gallium monocristallin, non dopé, mais qui pourrait être également dopé dans un type de conductivité quelconque. Ce substrat d'épaisseur quelconque est destiné à être éliminé au cours d'étapes ultérieures.

On fait croître, sur le substrat 3, par exemple par la méthode d'épitaxie organo-métallique, une couche 4 d'alliage de formule :

$$Ga_{1-x}Al_xAs$$

où x est compris entre zéro et 1, avec une valeur toutefois assez grande pour permettre une attaque chimique sélective par un agent qui épargne GaAs. Son épaisseur est par exemple de l'ordre du micron.

On fait croître, par une épitaxie analogue, sur la couche 4, une couche d'arséniure de gallium 5 avec un taux de dopage — non critique — de $5.10^{15}$ à $10^{16}\,cm^{-3}$ d'atomes de type n. L'épaisseur est par exemple de l'ordre du dixième de micron.

Sur les figures 4 et 5, on a représenté respectivement en coupe et en vue par-dessus, le résultat d'une étape de dépôt de métal sur la couche 5 de manière à former deux grilles interdigitées.

La grille $G_1$ comporte des doigts 31, 33 etc... perpendiculaires au plan de coupe de la figure 4.

La grille $G_2$ comporte des doigts 32, 34 etc... parallèles aux doigts 31, 33. La distance « d » entre les doigts 31 et 32 (ou entre 33 et 34) est fixée à une valeur prédéterminée en fonction du schéma de la figure 1, tandis que la distance entre les doigts 32 et 33 ou analogues peut être différente.

Sur les figures 6 et 7, on a représenté respectivement en coupe et en vue par-dessus, le résultat d'une étape où l'on a fait croître par épitaxie une couche 6 d'arséniure de gallium de façon à noyer les doigts des deux grilles $G_1$ et $G_2$. La couche 6 est limitée en largeur de telle sorte que l'on ait accès aux barres de grille pour les connecter aux générateurs de tension de polarisation.

L'arséniure de gallium de la couche 6 est dopé de façon identique à celui de la couche 5 : on réalise ainsi en pratique une couche unique 7

dans laquelle sont noyés les doigts des deux grilles $G_1$ et $G_2$.

Sur la figure 8, on a représenté en coupe le résultat d'une étape où l'on a déposé des contacts de source 10 sous forme de doigts parallèles aux doigts de grille 31 et 32, mais en ayant soin de placer chaque contact 10 à égale distance de chacun des doigts 31 et 32.

Les dimensions des rangées de doigts sont par exemple les suivantes :

— longueur 200 microns ;

— largeur : 0,1 micron ;

— épaisseur : 0,1 micron (ce qui fixe la « longueur » de grille du transistor) ;

— écartement entre deux doigts voisins de grille : 0,5 micron ;

— écartement entre deux contacts de source : 1 micron ;

La couche 7 est épaisse de 0,2 à 0,3 micron.

Sur la figure 9, on a représenté le résultat d'une étape où l'on a déposé un isolant 90, entre les contacts de source 10. A cet effet, on a préalablement protégé la partie supérieure des contacts 10 en déposant sélectivement à l'aide de procédés photolithographiques des pions de résine sur les contacts 10. Cette étape intermédiaire n'est pas représentée. Ensuite on a effectué un dépôt de silice ($SiO_2$) sur l'ensemble du dispositif et l'on a éliminé les pions de résine et la silice qui les recouvre, en faisant agir un solvant de la résine.

Sur la figure 10, on a représenté le résultat d'une étape où l'on a déposé une plaque métallique 100, relativement beaucoup plus épaisse que les couches semiconductrices 4 et 7, dont l'échelle est spécialement agrandie. La plaque 100 est destinée à permettre d'accéder, en parallèle, aux contacts de source 10. Elle déborde le bloc semiconducteur le long d'une arête 71 de ce dernier.

Les deux étapes suivantes consistent à éliminer le substrat semiconducteur et à lui substituer un support isolant du côté de la plaque 100.

Sur la figure 11 on a représenté une sous-étape intermédiaire de l'élimination du bloc semiconducteur, au cours de laquelle :

a) dans une première sous-étape, représenté à la figure 11, on attaque (flèches 110) le substrat 3 en arséniure de gallium à l'aide d'un agent chimique sélectif, par exemple un mélange de dix-neuf volumes d'eau oxygénée et d'un volume d'ammoniaque ;

b) dans une deuxième sous-étape, après l'élimination complète de l'arséniure de gallium du substrat on attaque l'arséniure de gallium et d'aluminium de la couche 4, à l'aide d'un agent chimique sélectif, par exemple un mélange en volumes égaux d'acide fluorhydrique et d'eau pure. On poursuit l'attaque chimique jusqu'à l'élimination complète de GaAlAs.

Sur la figure 12, on a représenté le résultat d'une étape où l'on a déposé sur la plaque 100, successivement :

— une couche 121 de résine de type époxy ;

— une couche 122 de verre assez épaisse pour permettre la manutention facile du dispositif.

Les étapes suivantes consistent à établir plusieurs rangées de contacts anodiques ou cibles à doigts parallèles aux doigts des grilles $G_1$ et $G_2$ (contacts Schottky 31 et 32).

Dans une première étape, on dépose une première rangée de doigts 21. A cet effet :

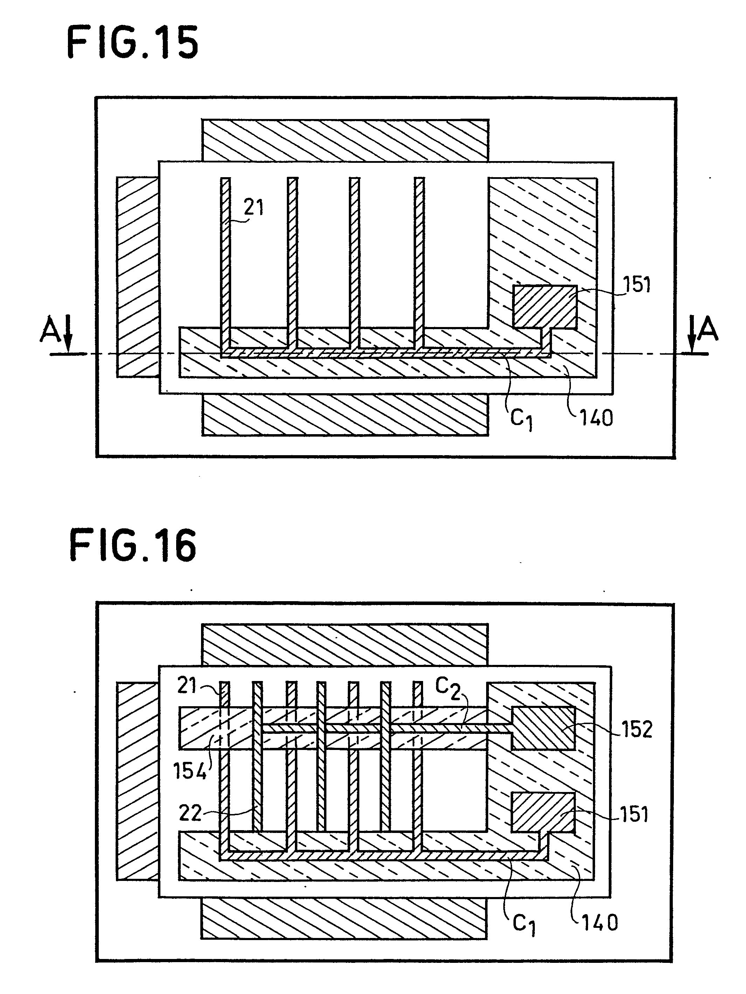

a) On réalise, par photolithographie, un masque de résine photosensible que l'on insole selon le dessin des cibles 21, constituant des doigts parallèles branchés sur une même bande $C_1$ (première rangée de cibles) comme on peut le voir figure 15. Pour former l'image latente de la rangée de cibles $C_1$ sur le masque de résine, on utilise des moyens optiques qu'il convient d'aligner avec précision sur la rangée de grilles 31 et 32. En effet dans chaque cellule, au sens qui a été défini ci-avant, les positions respectives des grilles et des anodes par rapport aux cathodes doivent être respectées strictement ainsi que le parallélisme des différentes électrodes. On utilise, pour rendre visibles ces doigts par transparence à travers l'arséniure de gallium, un microscope à lumière infrarouge (longueur d'onde supérieure à 0,9 micron).

On obtient après développement du masque de résine, dépôt de métal dans les sillons ainsi révélés, et enfin élimination de la résine restante, les résultats visibles en coupe à la figure 13.

b) Sur les figures 14 et 15 on a représenté en coupe et en vue par-dessus le résultat de sous-étapes où l'on a :

1. Déposé un isolant 140 entre les doigts 21 et à l'emplacement de la bande $C_1$ qui réunit les doigts 21.

2. Déposé sur l'isolant 140 la bande métallique $C_1$ et un plot de raccordement 151 relié à la bande $C_1$. Dans une deuxième étape, on effectue des opérations analogues à celles de l'étape précédente. Toutefois les dépôts de silice sont effectués de façon à isoler les bandes métalliques (à déposer) de la deuxième rangée de doigts et les bandes métalliques (déjà déposées) de la première rangée de doigts. On obtient ainsi le dispositif représenté à la figure 16, dans le cas où on se limite à deux rangées de doigts (21, 22).

On remarquera que :

1. La bande métallique $C_2$, réunissant les cibles 22 de la deuxième rangée est déposée sur une couche isolante 154 qui recouvre la première rangée de doigts 21.

2. Cette bande $C_2$ est reliée à un plot de raccordement 152 déposé sur la couche isolante 154.

Dans le cas d'une commutation à trois cibles ou plus, le pas de la rangée de doigts de chaque cible reste égal à la distance séparant deux contacts de source consécutifs, soit 1 micron dans l'exemple précité, l'écart entre les cibles étant inférieur au micron.

Le procédé de fabrication d'un dispositif déphaseur selon l'invention comporte des étapes identiques à celles qui viennent d'être décrites, à l'exception des dernières étapes concernant le dépôt des contacts anodiques. Ces étapes sont remplacées par une étape unique au cours de

laquelle on effectue un dépôt métallique sur la couche 7 (figure 12) pour constituer l'électrode 20 de cible, comme il a été représenté sur la figure 2.

**Revendications**

1. Dispositif de déviation d'électrons du type « à transport balistique », dans lequel on trouve une structure comportant au moins une cathode (10) et au moins une anode (21), ces deux électrodes étant situées de part et d'autre d'une lame (1) semiconductrice avec laquelle ils forment des contacts ohmiques permettant d'observer le phénomène des électrons balistiques, ladite lame comportant une première électrode (31) enterrée, formant un premier contact Schottky, le dispositif étant caractérisé en ce que la structure comporte une deuxième électrode (32) enterrée, formant un deuxième contact Schottky des moyens étant prévus pour appliquer des tensions ($V_1$, $V_2$) de polarisation à la première et à la deuxième électrodes (31, 32), de telle sorte que le courant d'électrons ($E_0$) soit dévié en fonction de la différence de potentiel entre les électrodes (31, 32) enterrées.

2. Dispositif selon la revendication 1, caractérisé en ce qu'il comporte en outre au moins une électrode anodique (22) supplémentaire disposée de telle sorte que le courant électrique passe par l'une ou par l'autre des électrodes anodiques lorsqu'on modifie d'une quantité déterminée le rapport des tensions ($V_1$, $V_2$) appliquées respectivement à la première et à la deuxième électrode enterrée.

3. Dispositif selon la revendication 1, caractérisé en ce que l'électrode anodique (20) est de longueur suffisante pour faire apparaître une différence de temps de parcours entre cathode et anode pour les électrons balistiques, lorsque ceux-ci sont dirigés en raison des polarisations différentes ($V_1$, $V_2$) appliquées aux électrodes enterrées sur différents points de l'électrode anodique.

4. Dispositif selon la revendication 2, caractérisé en ce que la cathode, les grilles et les anodes forment des rangées d'électrodes parallèles et en ce que les électrodes enterrées sont interdigitées.

5. Dispositif selon la revendication 3, caractérisé en ce que la cathode et les électrodes enterrées forment des rangées d'électrodes parallèles et en ce que les électrodes enterrées sont interdigitées.

6. Dispositif selon l'une quelconque des revendications 1, 2 et 3, caractérisé en ce que la lame semiconductrice est en arséniure de gallium dopé avec un taux compris entre $5.10^{15}$ et $1.10^{16}$ $cm^{-3}$ d'atomes de dopant de type n, l'épaisseur de la lame étant inférieure au micron.

7. Procédé de fabrication d'un dispositif selon l'une quelconque des revendications 1 à 6, caractérisé en ce qu'il comporte au moins les étapes suivantes effectuées en partant d'un substrat (3) parallélépipédique fait d'un premier matériau semiconducteur :

(A) Dépôt, par épitaxie, d'une première couche (4) d'un deuxième matériau semiconducteur revêtant une grande face du substrat et capable d'être éliminée par attaque chimique sélective à l'aide d'un agent épargnant le premier matériau ;

(B) Dépôt, par épitaxie sur la première couche, d'une deuxième couche (5) de matériau identique au premier matériau ;

(C) Dépôt de métal en deux points au moins de la deuxième couche pour constituer deux contacts (31, 32) du type Schottky ;

(D) Dépôt par épitaxie sur la deuxième couche et sur les contacts Schottky (31, 32), d'une troisième couche (6) de matériau identique au premier matériau de manière à noyer les contacts Schottky (31, 32) dans le premier matériau ;

(E) Dépôt de métal de manière à réaliser au moins un contact ohmique (10) sur la troisième couche ;

(F) Dépôt d'une couche isolante (90) sur la troisième couche en épargnant les contacts ohmiques (10) ;

(G) Dépôt d'une plaque métallique (100) sur l'isolant (90) et les contacts ohmiques en débordant le matériau semiconducteur ;

(H) Elimination du substrat semiconducteur (3) par un agent d'attaque sélective du premier matériau ;

(I) Elimination de la première couche (4) par agent d'attaque sélective du deuxième matériau ;

(J) Dépôt, sur la plaque (100) déposée à l'étape (G) d'au moins un matériau isolant (121, 122) susceptible de constituer un nouveau substrat ;

(K) Dépôt, sur la couche (7) mise à nu par attaque chimique effectuée à l'étape (I) d'au moins un contact ohmique (21).

8. Procédé selon la revendication 7, caractérisé en ce qu'en vue de déposer au moins deux rangées de contacts ohmiques à l'issue de l'étape (J), on dépose, sur la première rangée de contacts ohmiques déposés à l'étape (K), une couche isolante (154) recouvrant partiellement les contacts de la première rangée afin de permettre le croisement d'une métallisation reliant les contacts de la deuxième rangée tout en isolant entre eux les contacts des deux rangées.

9. Procédé selon la revendication 7, caractérisé en ce qu'en vue de constituer un dispositif déphaseur, le contact ohmique de l'étape (K) présente une longueur suffisante pour que l'on observe une différence de temps de parcours des électrons balistiques entre cathode et anode selon les points de l'anode qui sont atteints.

10. Procédé selon la revendication 8, caractérisé en ce que, entre les étapes (J) et (K), on dépose une bande isolante (140) destinée à être partiellement recouverte par les extrémités des bandes métalliques constituant la première rangée de contacts ohmiques et à recevoir une métallisation ($C_1$) reliant les contacts de la première rangée avec un plot de raccordement (151), puis on dépose ladite métallisation et ledit plot de raccordement (151).

11. Procédé selon la revendication 10, caractérisé en ce qu'au cours d'une étape succédant à l'étape (K), on dépose sur la couche isolante (154) recouvrant partiellement les contacts ohmiques de la première rangée, la métallisation ($C_2$) destinée à relier les contacts ohmiques de la deuxième rangée en même temps que les contacts ohmiques de la deuxième rangée recouvrant partiellement le matériau semiconducteur et ladite couche isolante, enfin sur ladite couche isolante, un plot de raccordement (152) de la deuxième rangée de contacts ohmiques.

**Claims**

1. Electron deflection device of the « ballistic transport » type including a structure comprising at least one cathode (10) and at least one anode (21) these electrodes being located on both sides of a semiconductor chip (1) with which they form ohmic contacts permitting to observe the phenomenon of ballistic electrons, said chip carrying a first buried electrode (31) forming a first Schottky contact, the device being characterized in that the structure comprises a second buried electrode (32) forming a second Schottky contact, means being provided to apply polarization voltages ($V_1$, $V_2$) to the first and second electrodes (31, 32) in such a manner that the electron current ($E_0$) is deflected as a function of the potential difference between the buried electrodes (31, 32).

2. Device according to claim 1, characterized in that it further comprises at least one additional anode electrode (22) disposed in such a manner that the electric current passes through one or the other of the anode electrodes when the ratio of the voltages ($V_1$, $V_2$) respectively applied to the first and second buried electrodes is modified by a determined quantity.

3. Device according to claim 1, characterized in that the anode electrode (20) has a sufficient length to cause the appearance of a transit time difference between cathode and anode for ballistic electrons when these are directed to different points of the anode electrode due to different polarizations ($V_1$, $V_2$) being applied to the buried electrodes.

4. Device according to claim 2, characterized in that the cathode, the gate and the anode form parallel rows of electrodes and in that the buried electrodes are interdigitated.

5. Device according to claim 3, characterized in that the cathode and the buried electrodes form parallel rows of electrodes and in that the buried electrodes are interdigitated.

6. Device according to any of claims 1, 2 and 3, characterized in that the semiconductor chip is of gallium arsenide doped with a doping level comprised between $5.10^{15}$ and $1.10^{16}$ $cm^{-3}$ atoms of a dopant of n type, the thickness of the chip being less than one micron.

7. Method of producing a device according to any of claims 1 to 6, characterized in that it comprises at least the following steps which are performed starting from a parallelepiped-shaped substrate (3) of a first semiconductor material :

(A) Epitaxial deposition of a first layer (4) of a second semiconductor material coating one major face of the substrate and capable of being eliminated by chemical selective attack using an agent leaving the first material ;

(B) Epitaxial deposition of a second layer (5) of a material identical to the first material on the first layer ;

(C) Deposition of metal at at least two points of the second layer to form two contacts (31, 32) of Schottky type ;

(D) Epitaxial deposition on the second layer and on the Schottky contacts (31, 32) of a third layer (6) of a material identical to the first material in a manner to embed the Schottky contacts (31, 32) within the first material ;

(E) Deposition of metal in such a manner that at least one ohmic contact (10) is formed on the third layer ;

(F) Deposition of an insulating layer (90) on the third layer leaving the ohmic contacts (10) ;

(G) Deposition of a metallic plate (100) onto the insulation (90) and the ohmic contacts projecting beyond the semiconductor material ;

(H) Elimination of the semiconductor substrate (3) using an agent for selective attack of the first material ;

(I) Elimination of the first layer (4) using an agent for selective attack of the second material ;

(J) Deposition on the plate (100) deposited in step (G) of at least one insulating material (121, 122) adapted to form a new substrate ;

(K) Deposition of at least one ohmic contact (21) on the layer (7) bared by chemical attack of step (I).

8. Method according to claim 7, characterized in that, in order to deposit at least two rows of ohmic contacts at the end of step (J), an insulating layer (154) partially covering the contacts of the first row is deposited on the first row of ohmic contacts deposited in step (K) in order to permit the crossing of a metallization connecting the contacts of the second row while the contacts of the two rows are insulated from each other.

9. Method according to claim 7, characterized in that, in order to form a phase shifting device, the ohmic contact of step (K) has a length sufficient to cause a transit time difference of the ballistic electrons to be observed between cathode and anode in dependence on the points of the anode which are reached.

10. Method according to claim 8, characterized in that, between steps (J) and (K), an insulating strip (140) is deposited which is susceptible to be partially covered by the ends of the metallic strips forming the first row of ohmic contacts and to receive a metallization ($C_1$) connecting the contacts of the first row to a connection terminal (151), and subsequently said metallization ($C_1$) and said connection terminal (151) are deposited.

11. Method according to claim 10, characterized in that, in a step following step (K), the metallization ($C_2$) susceptible to connect the

ohmic contacts of the second row is deposited on the insulating layer (154) partially covering the ohmic contacts of the first row simultaneously with the ohmic contacts of the second row partially covering the semiconductor material and said insulating layer, and finally a connection terminal (152) for connecting the second row of ohmic contacts is deposited on said insulating layer.

**Ansprüche**

1. Elektronen-Ablenkvorrichtung vom Typ « mit ballistischem Transport », in welcher eine Struktur mit wenigstens einer Katode (10) und wenigstens einer Anode (21) enthalten ist, wobei diese beiden Elektroden auf der einen bzw. anderen Seite einer Halbleiterscheibe (1) liegen, mit der sie ohmsche Kontakte bilden, die es gestatten, die Erscheinung ballistischer Elektronen zu beobachten, wobei diese Scheibe eine erste vergrabene Elektrode (31) aufweist, die einen ersten Schottky-Kontakt bildet, wobei die Vorrichtung dadurch gekennzeichnet ist, daß die Struktur eine zweite vergrabene Elektrode (32) enthält, die einen zweiten Schottky-Kontakt bildet, wobei Mittel vorgesehen sind, um Polarisationsspannungen ($V_1$, $V_2$) an die erste und an die zweite Elektrode (31, 32) derart anzulegen, daß der Elektronenstrom ($E_0$) in Abhängigkeit von der Potentialdifferenz zwischen den vergrabenen Elektroden (31, 32) abgelenkt wird.

2. Vorrichtung nach Anspruch 1, dadurch gekennzeichnet, daß sie ferner wenigstens eine zusätzliche Anodenelektrode (22) enthält, welche derart angeordnet ist, daß der Elektronenstrom über die eine oder die andere der Anodenelektroden fließt, wenn das Verhältnis der an die erste und an die zweite vergrabene Elektrode angelegten Spannungen ($V_1$, $V_2$) um eine vorbestimmte Größe verändert wird.

3. Vorrichtung nach Anspruch 1, dadurch gekennzeichnet, daß die Anodenelektrode (20) eine ausreichende Länge aufweist, damit eine Laufzeitdifferenz zwischen Katode und Anode für die ballistischen Elektronen in Erscheinung tritt, wenn diese aufgrund der unterschiedlichen Polarisationen ($V_1$, $V_2$), welche an die vergrabenen Elektroden angelegt werden, zu verschiedenen Punkten der Anodenelektrode gerichtet werden.

4. Vorrichtung nach Anspruch 2, dadurch gekennzeichnet, daß die Katode, die Gate-Elektroden und die Anoden Reihen von parallelen Elektroden bilden und daß die vergrabenen Elektroden interdigital ineinandergreifen.

5. Vorrichtung nach Anspruch 3, dadurch gekennzeichnet, daß die Katode und die vergrabenen Elektroden parallele Reihen von Elektroden bilden und daß die vergrabenen Elektroden interdigital ineinandergreifen.

6. Vorrichtung nach einem der Ansprüche 1, 2 und 3, dadurch gekennzeichnet, daß die Halbleiterscheibe aus Galliumarsenid ist, welches mit einem Niveau zwischen $5.10^{15}$ und $1.10^{16}$ $cm^{-3}$ Atomen eines Dotierungsstoffes vom n-Typ dotiert ist, wobei die Dicke der Scheibe weniger als ein Mikron beträgt.

7. Verfahren zur Herstellung einer Vorrichtung nach einem der Ansprüche 1 bis 6, dadurch gekennzeichnet, daß es wenigstens die folgenden Schritte enthält, die ausgehend von einem quaderförmigen Substrat (3) aus einem ersten Halbleitermaterial ausgeführt werden :

(A) Epitaktisches Aufbringen einer ersten Schicht (4) aus einem zweiten Halbleitermaterial, welches eine Hauptfläche des Substrates bedeckt und durch selektiven chemischen Angriff durch ein Mittel entfernt werden kann, welches das erste Material nicht angreift ;

(B) Epitaktisches Aufbringen einer zweiten Schicht (5) aus demselben Material wie das erste Material auf der ersten Schicht ;

(C) Ablagern von Metall an wenigstens zwei Punkten der zweiten Schicht, um zwei Kontakte (31, 32) vom Schottky-Typ zu bilden ;

(D) Epitaktisches Aufbringen einer dritten Schicht (6) aus demselben Material wie das erste Material auf der zweiten Schicht und über den Schottky-Kontakten (31, 32) in der Weise, daß die Schottky-Kontakte (31, 32) in dem ersten Material eingebettet sind ;

(E) Ablagern von Metall in der Weise, daß wenigstens ein ohmscher Kontakt (10) auf der dritten Schicht gebildet wird ;

(F) Aufbringen einer Isolierschicht (90) auf der dritten Schicht unter Aussparung der ohmschen Kontakte (10) ;

(G) Aufbringen einer Metallscheibe (100) auf der Isolierung (90) und den ohmschen Kontakten und über das Halbleitermaterial hinausstehend ;

(H) Beseitigung des Halbleitersubstrats (3) durch ein Mittel, welches das erste Material selektiv angreift ;

(I) Beseitigung der ersten Schicht (4) durch ein Mittel, welches das zweite Material selektiv angreift ;

(J) Aufbringen wenigstens eines Isoliermaterials (121, 122), das ein neues Substrat bilden kann, auf der im Schritt (G) aufgebrachten Scheibe (100) ;

(K) Aufbringen wenigstens eines ohmschen Kontaktes (21) auf der im Schritt (I) durch chemischen Angriff freigelegten Schicht (7).

8. Verfahren nach Anspruch 7, dadurch gekennzeichnet, daß zum Aufbringen von wenigstens zwei Reihen von ohmschen Kontakten am Ende des Schrittes (J) auf der ersten Reihe von ohmschen Kontakten, die im Schritt (K) aufgebracht wurden, eine Isolierschicht (154) aufgebracht wird, welche die Kontakte der ersten Reihe teilweise bedeckt, um die Überkreuzung durch eine Metallisierung zu ermöglichen, welche die Kontakte der zweiten Reihe verbindet, während die Kontakte der zwei Reihen untereinander isoliert bleiben.

9. Verfahren nach Anspruch 7, dadurch gekennzeichnet, daß zur Bildung einer Phasenschiebervorrichtung der ohmsche Kontakt im Schritt (K) eine ausreichende Länge aufweist,

damit eine Laufzeitdifferenz der ballistischen Elektronen zwischen Katode und Anode je nach den erreichten Anodenpunkten beobachtet wird.

10. Verfahren nach Anspruch 8, dadurch gekennzeichnet, daß zwischen den Schritten (J) und (K) ein Isolierstreifen (140) aufgebracht wird, der dazu bestimmt ist, teilweise durch die Enden der Metallstreifen bedeckt zu werden, welche die erste Reihe von ohmschen Kontakten bilden, und eine Metallisierung ($C_1$) zu erhalten, welche die Kontakte der zweiten Reihe mit einem Anschlußklötzchen (151) verbindet, woraufhin die genannte Metallisierung ($C_1$) und das genannte Anschlußklötzchen (151) aufgebracht werden.

11. Verfahren nach Anspruch 10, dadurch gekennzeichnet, daß im Verlauf eines Schrittes, der auf den Schritt (K) folgt, auf der Isolierschicht (154), welche die ohmschen Kontakte der ersten Reihe teilweise bedeckt, die Metallisierung ($C_2$) aufgebracht wird, welche dazu bestimmt ist, die ohmschen Kontakte der zweiten Reihe zu verbinden, gleichzeitig mit den ohmschen Kontanten der zweiten Reihe, welche das Halbleitermaterial und die genannte Isolierschicht teilweise bedecken, woraufhin schließlich auf der genannten Isolierschicht ein Anschlußklötzchen (152) für die zweite Reihe von ohmschen Kontakten aufgebracht wird.

FIG.2

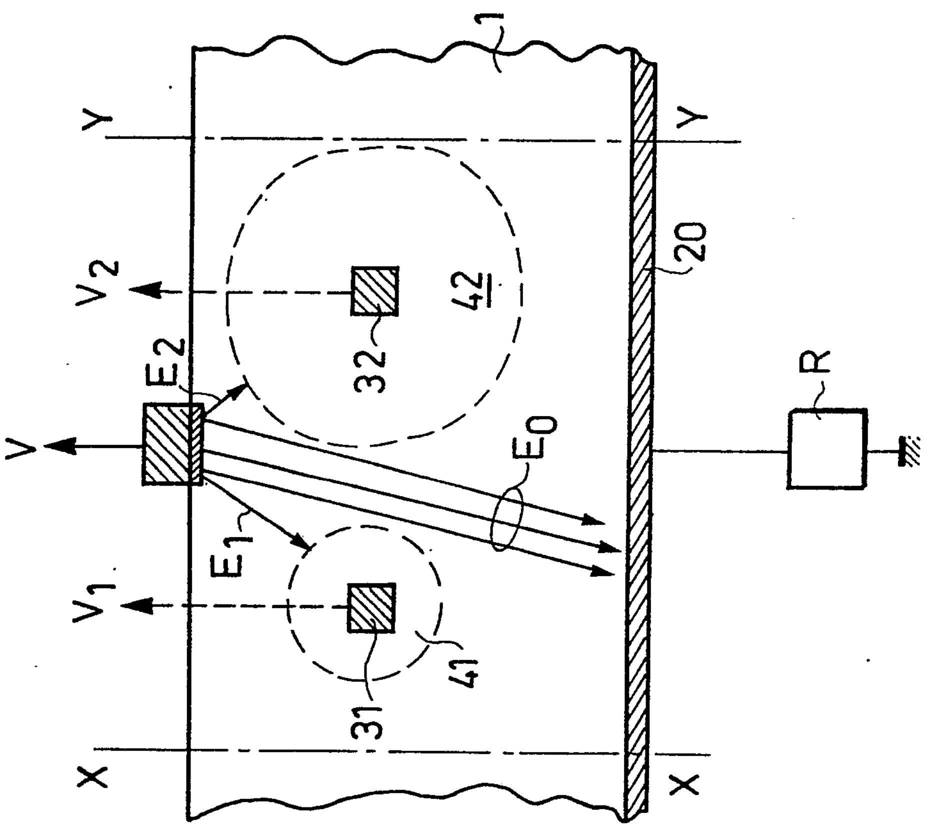

1
Y
Y
X
X
$V_2$
V
$V_1$
$E_2$
$E_1$
$E_0$
32
42
31
41
20
R


FIG.1

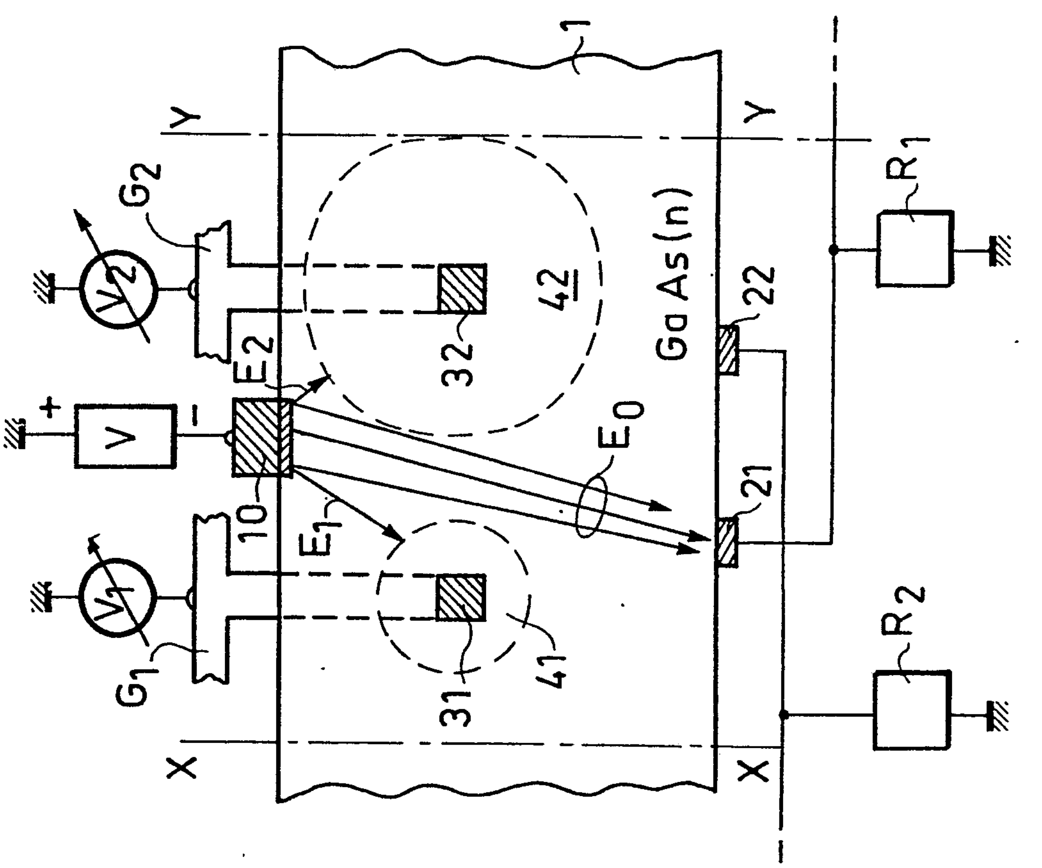

1
Y
Y
X
X
$G_1$
$G_2$
$V_1$
$V_2$
V
+
−
10
$E_1$
$E_2$
$E_0$
31
41
32
42
Ga As (n)
21
22
$R_1$
$R_2$

FIG. 3

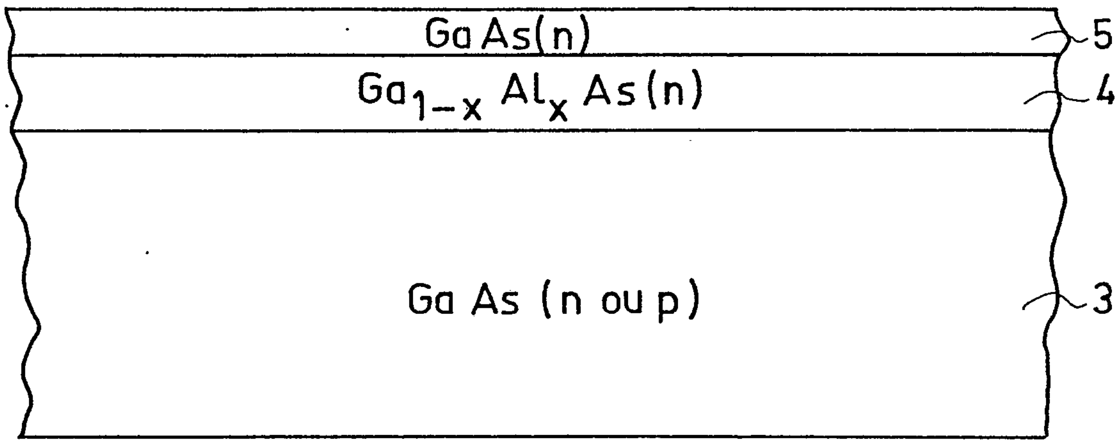


FIG. 4

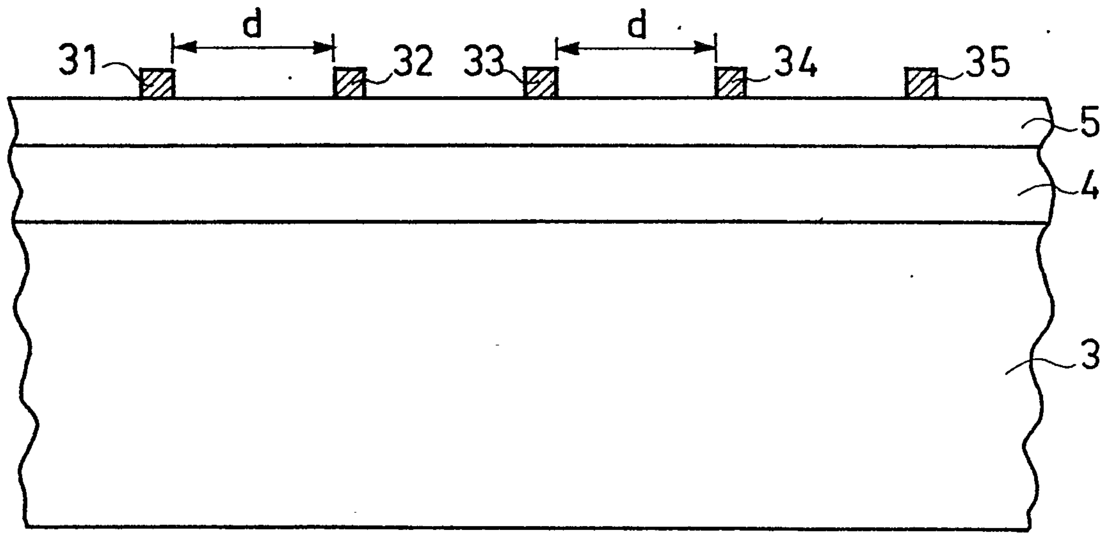


FIG. 6

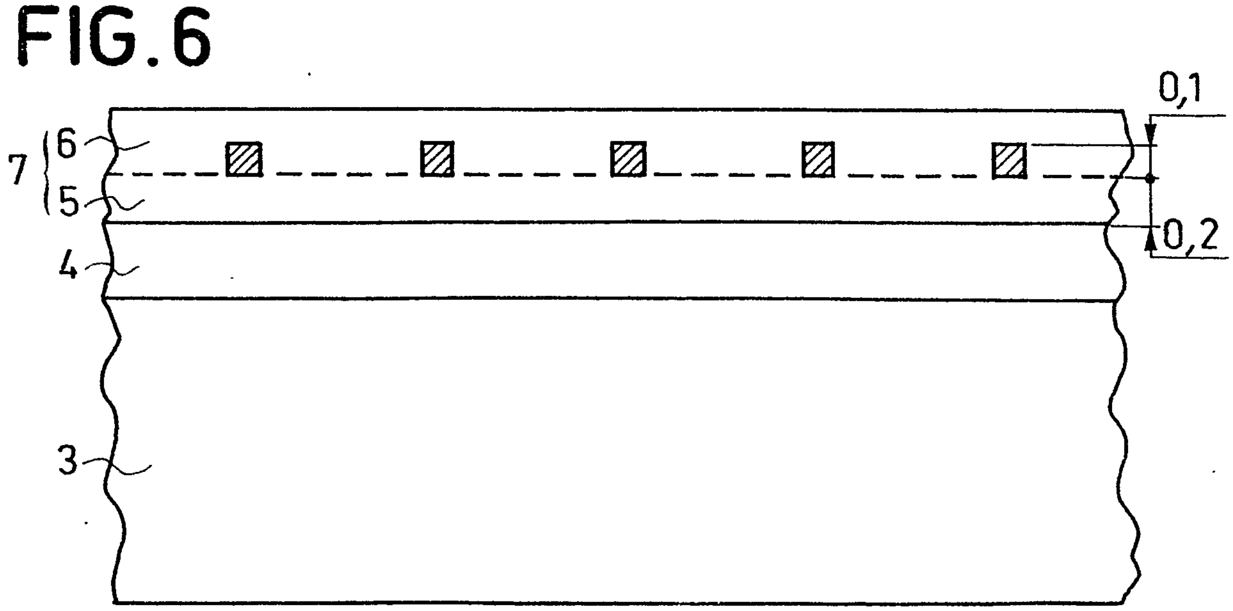

FIG. 5

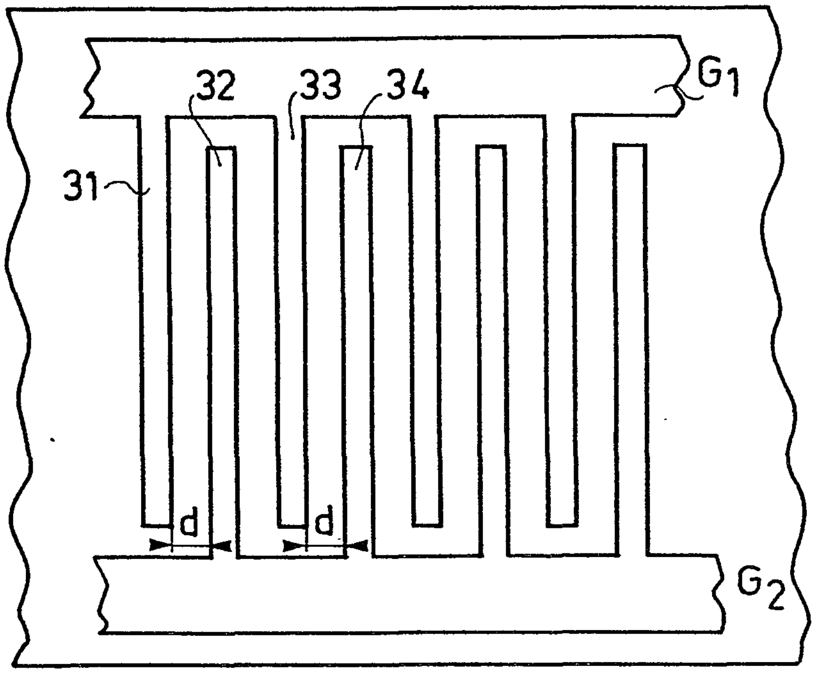


FIG. 7

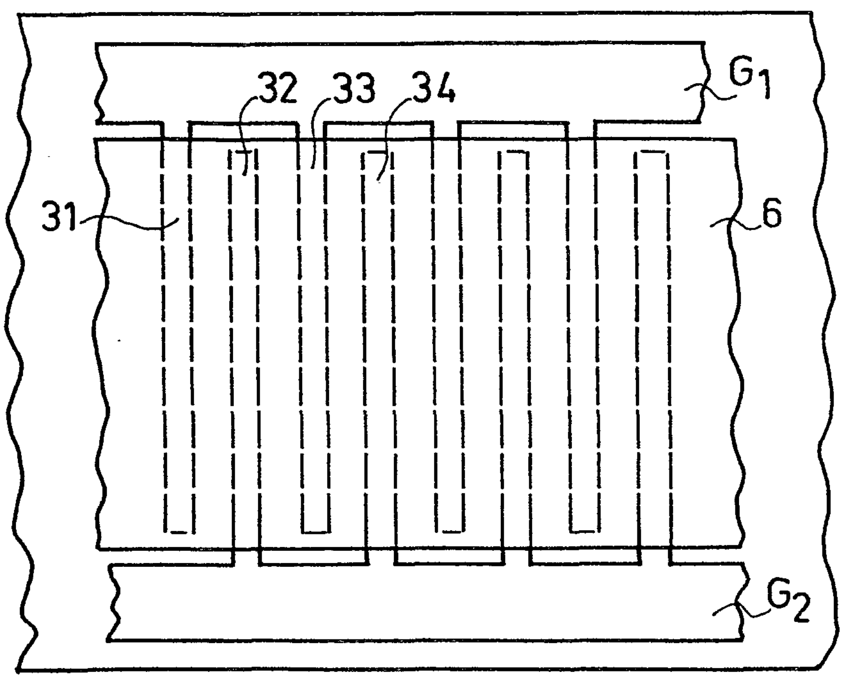

FIG.8

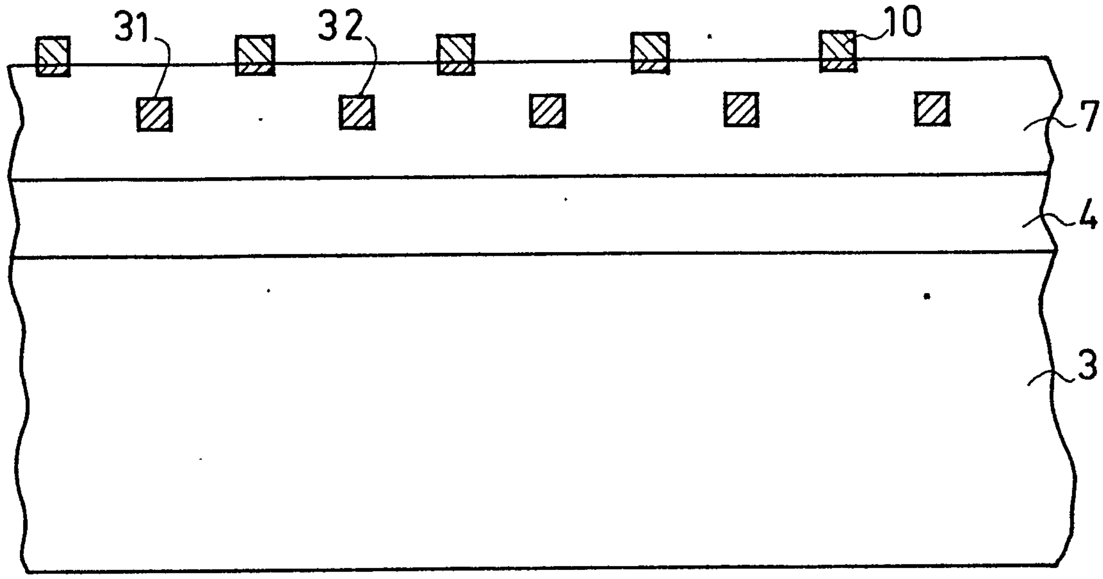


FIG.9

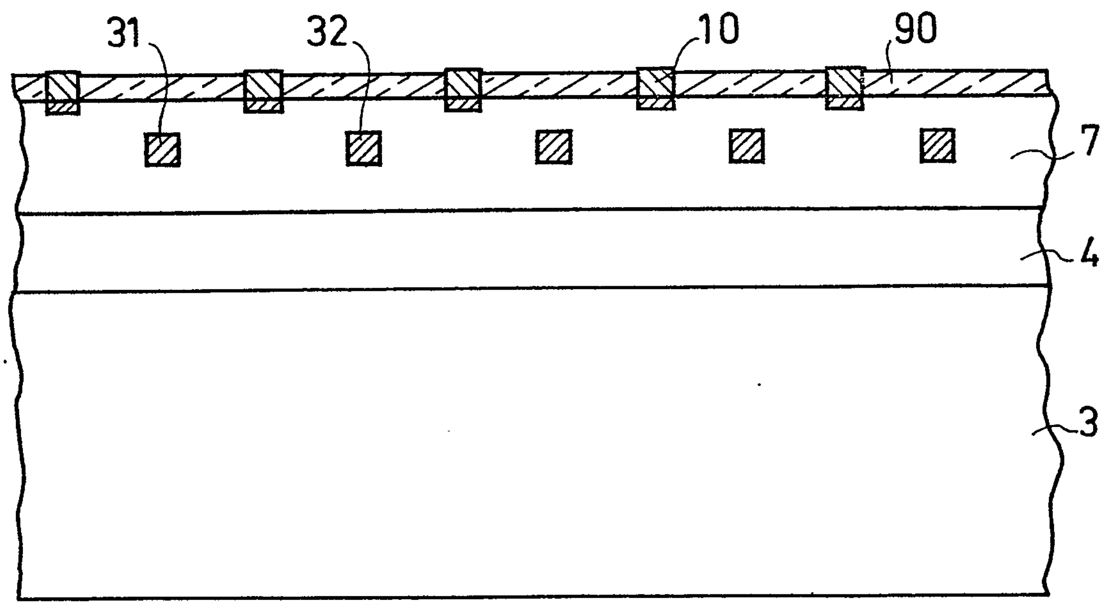


FIG.10

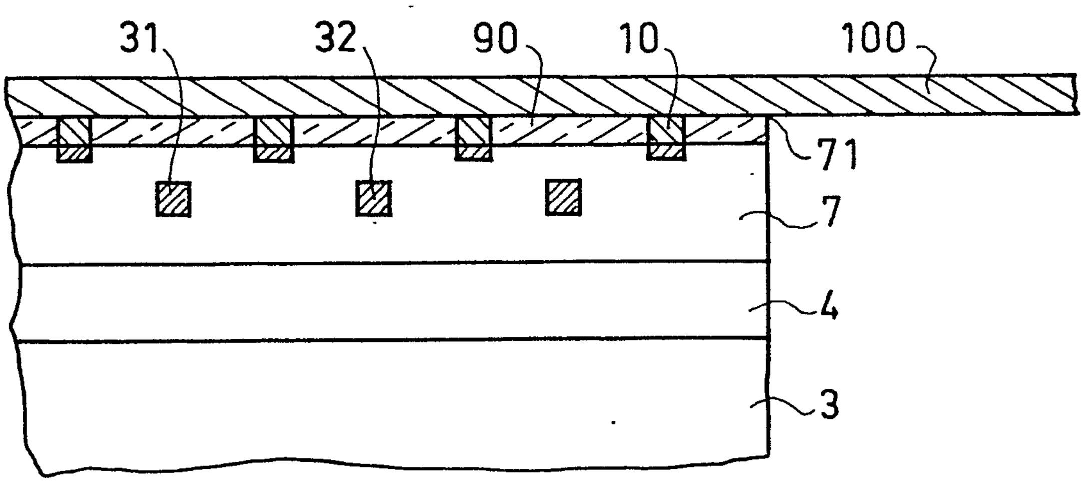

FIG.11

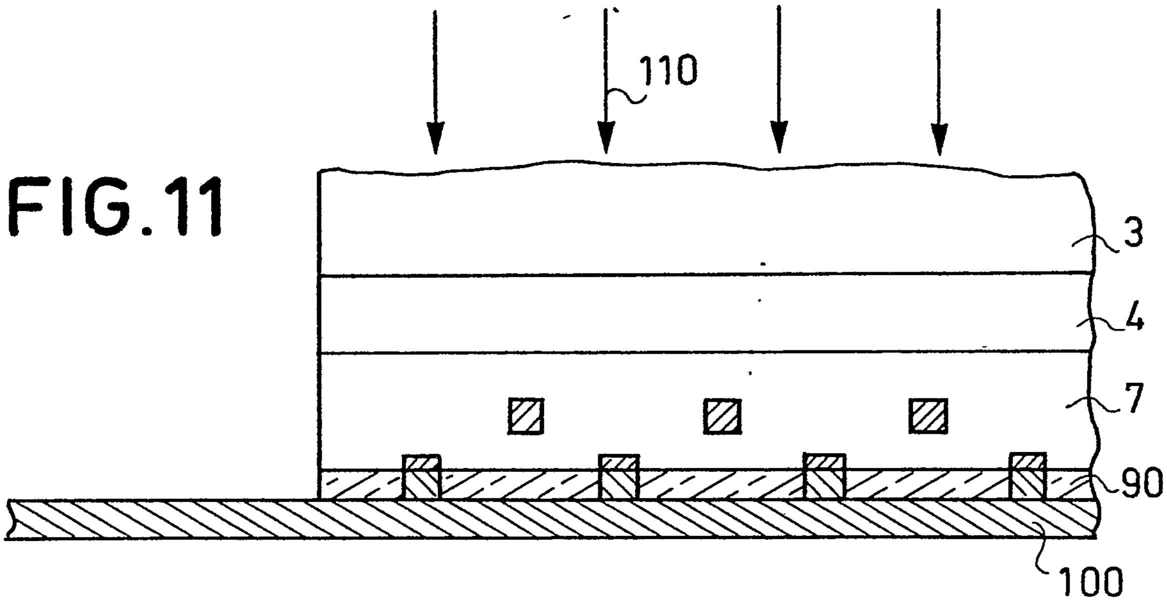


FIG.12

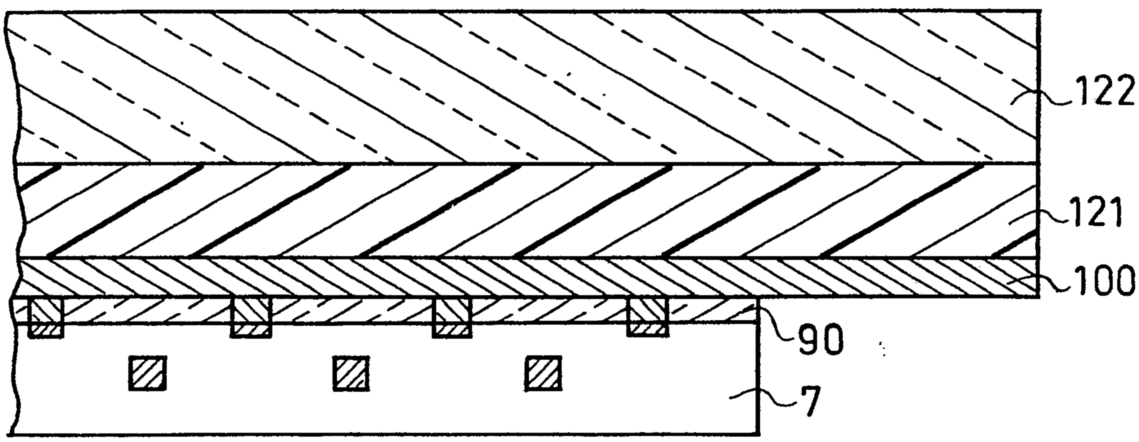


FIG.13

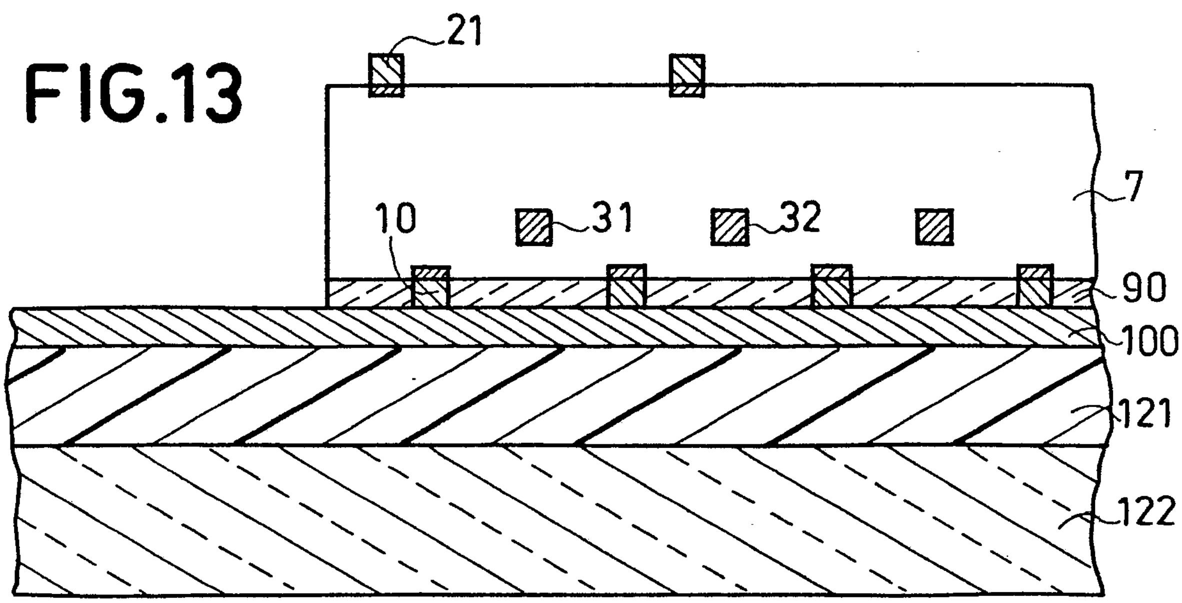

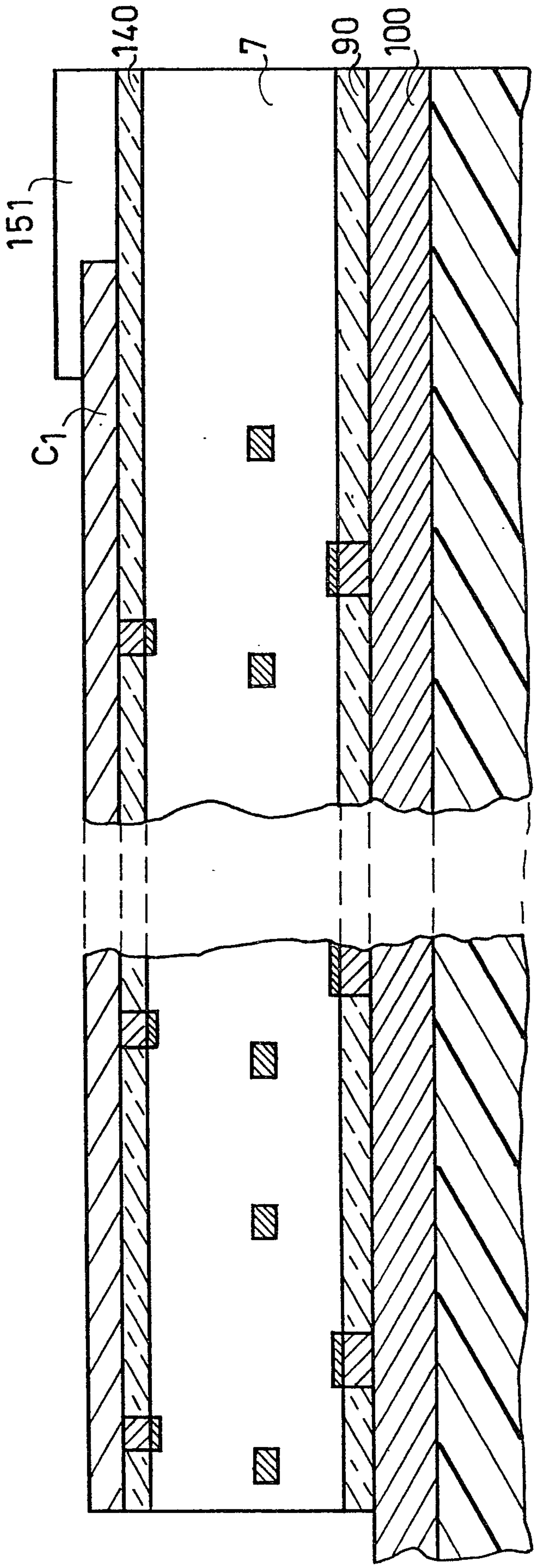


FIG. 14

FIG.15

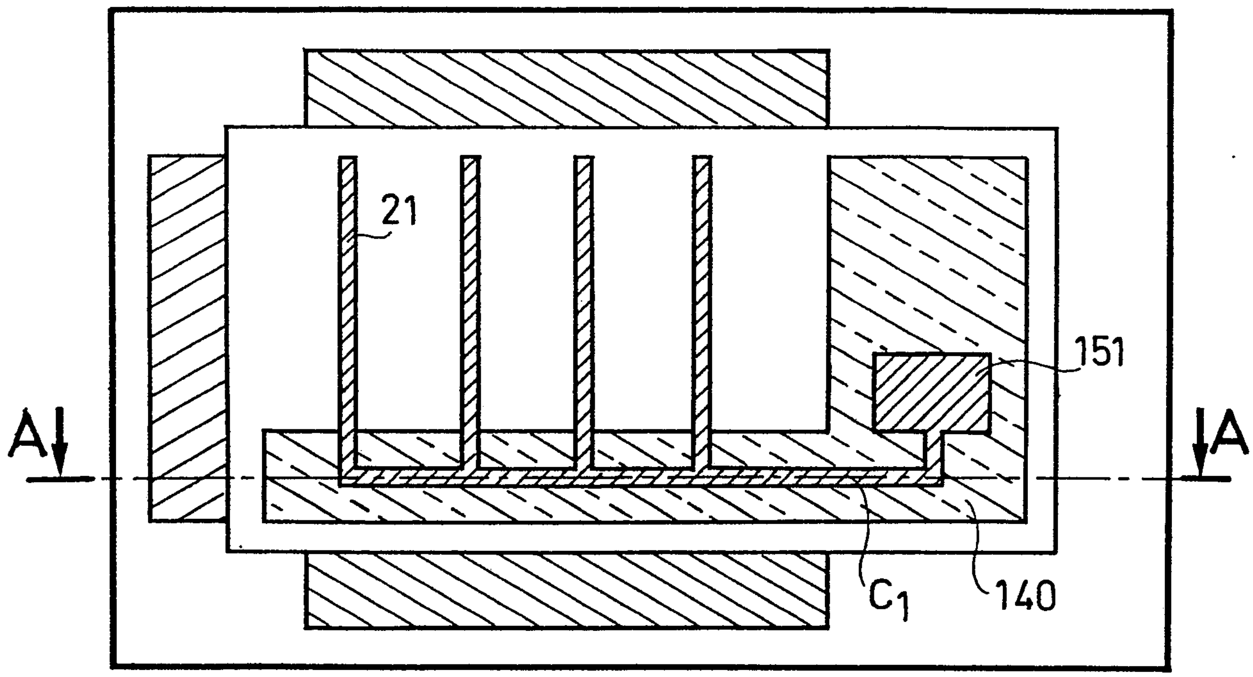


FIG.16